# EUROPEAN PATENT SPECIFICATION

(11) **EP 2 078 309 B1**
(45) Date of publication and mention of the grant of the patent: **15.12.2010**
(21) Application number: 07871441.7
(22) Date of filing: 12.11.2007
(51) Int. Cl.: H01L 31/0352, H01L 31/052

(54) **CURVED FOCAL PLANE RECEIVER FOR CONCENTRATING LIGHT IN A PHOTOVOLTAIC SYSTEM**
EMPFÄNGER MIT GEKRÜMMTER FOKALEBENE ZUM KONZENTRIEREN VON LICHT IN EINEM FOTOVOLTAGENSYSTEM
RÉCEPTEUR À PLAN FOCAL INCURVÉ ADAPTÉ POUR CONCENTRER UNE LUMIÈRE DANS UN SYSTÈME PHOTOVOLTAÏQUE

(30) Priority: 21.11.2006 US 562196
(43) Date of publication of application: 15.07.2009
(73) Proprietor: The Boeing Company, Chicago, IL 60606-2016 (US)
(72) Inventor: KINSEY, Geoffrey S., Pasadena, California 91106 (US)
(74) Representative: McLeish, Nicholas Alistair Maxwell
(86) International application number: PCT/US2007/084426
(87) International publication number: WO 2008/070408

(56) References cited:
- WO-A-96/11501
- US-A- 5 882 434
- US-A- 5 961 739
- US-A1- 2003 037 814

## Description

The present invention relates to an apparatus for generating energy using solar cells. More particularly, the present invention relates to an apparatus for generating energy using solar cells in a concentrating photovoltaic system.

### Background:

One type of solar energy involves the use of solar cells to generate electricity. This type of solar power technology is also referred to as photovoltaics. The solar cells used are semiconductor devices that convert photons into electricity. Individual solar cells may be grouped together to form modules, which in turn, may be arranged into groupings called solar arrays. Concentrating photovoltaics are widely regarded as a key in making solar energy cost competitive with respect to other energy sources, such as fossil fuels.

With concentrating photovoltaics, sunlight is collected from a large area and concentrated on a relatively small receiver area through the use of some combination of reflective and/or refractive optics. The receiver area is covered with one or more solar cells that convert the sunlight into electricity. Concentrating the sunlight on the receiver area increases the efficiency of the solar cells. Additionally, by concentrating the sunlight, the number of solar cells required to produce a given power output is reduced.

In this manner, the cost in generating electricity is reduced because the component cost for the relatively expensive solar cells is decreased. In concentrating photovoltaic systems, a tracking system is used to follow the sun through the sky to maintain a focus of the sunlight on the solar cells in the receiver area. In order for a concentrating photovoltaic system to function properly, the sunlight should be focused precisely and uniformly on the solar cell. Currently, this focusing has been accomplished through the design of the shape of the concentrating optical elements that direct light onto the receiver area.

The optical elements in the reflective and/or refractive optics are designed to produce uniform, high-intensity illumination on the typically flat focal plane of the receiver area. Achieving uniform high-intensity illumination on a flat focal plane of a receiver is difficult and requires high precision optics. The reflective systems use elements, such as mirrors, to reflect and concentrate the sunlight onto the solar cells. The refractive systems use lenses to concentrate the sunlight onto the solar cells. In either case, a homogenizer may be used to uniformly distribute the reflected/refracted light on the cell surfaces.

In many cases, a complex combination of mirrors, lenses, and homogenizers are required to maximize the efficiency of the solar cells in the receiver area. In practice, a compromise is often made between achieving the ultimate optical efficiency and producing optical elements at a reasonable cost.

US 5,961,739 discloses a hemispheric moving focus power plant which has a hemispheric solar reflector for reflecting solar energy. A receiver for receiving reflected solar energy and producing power therefrom is movably connected to the hemispheric solar reflector. The receiver includes a frame with a top, to which a plurality of photovoltaic cells are connected, and a support. Further, a power conditioner is connected to the receiver for receiving power from the receiver and conditioning the power for use.

Further, this type of system requires a high precision tracking system. Typically, a tracking system that has less than 0.5 degrees tracking error with respect to the sun is often used in order to obtain high concentration, such as greater than 500x.

In addition, uniform high-intensity illumination should be produced over the receiver area that is covered with solar cells. These high-intensity illumination powered densities may be, for example, 50-100 W/cm². These types of power densities can deliver very high system efficiencies, but also can create large potential differences within a solar cell and between solar cells connected in a circuit. If the illumination is not uniform, differences in current output develops in the solar cells. These differences may lead to resistive power loss and unpredictable electric fields within the solar cells, causing degradation and leading to a solar cell failure.

A compromise is typically made between the expense of the concentrating optics, the performance, and/or the reliability level that is deemed acceptable for a concentrating photovoltaic system. In this type of system, light falls on the cells in the receiver area at an angle that is off-normal (less than 90 degrees). For off-normal illumination, the cell presents a smaller cross-section to the incident light. As a result, the effective illumination is often reduced. For example, for typical systems using around 500 times concentrating, the off-normal angle is often as much as 30 degrees. With this type of angle, the illumination intensity may be reduced by more than 15 percent. With such off-angle illumination, slight deviations in the optical path of the concentrated illumination beam can cause portions of the beam to miss the cell receiver area, These deviations may be caused by tracking errors, imperfections in the optics, deformation of the optics due to thermal expansion, or wind loading, or the like.

A secondary effect is caused by the anti-reflection coating on the solar cells that is optimized for normal incident illumination. As a result, the off-normal illumination tends to be reflected off the solar cell rather than being absorbed and converted to power by the solar cell. Homogenizers may be used to mitigate this effect. This type of element, however, contributes to optical losses and adds to the cost of a concentrating photovoltaic system.

Thus, creating concentrating photovoltaic systems at a reasonable cost to produce energy is difficult. Therefore, it would be advantageous to have an improved method and apparatus for concentrating light on solar cells.

### SUMMARY OF THE INVENTION

According to the present invention there is provided a concentrating photovoltaic system as claimed in the appended claims.

An embodiment of the present invention provides an apparatus having a concentrating optic member, wherein the concentrating optic member redirects light to form concentrated illumination. The apparatus also has a structure with a curved surface positioned to receive the redirected light and a set of solar cells connected to curved surface of the structure, wherein the curved surface is substantially concave with a bulge in the center extending towards the concentrating optic member such that some of the reflected light rays are reflected from a solar cell and absorbed by the adjacent solar cells.

The features, functions, and advantages can be achieved independently in various embodiments of the present invention or may be combined in yet other embodiments.

### BRIEF DESCRIPTION OF THE DRAWINGS

The novel features believed characteristic of the invention are set forth in the appended claims. The invention itself, however, as well as a preferred mode of use, further objectives and advantages thereof, will best be understood by reference to the following detailed description of an advantageous embodiment of the present invention when read in conjunction with the accompanying drawings, wherein:
**Figure 1** is a diagram illustrating a solar powered generation system;
**Figure 2** is a diagram illustrating a concentrating photovoltaic system;
**Figure 3** is a diagram of another concentrating photovoltaic unit;
**Figure 4** is a diagram of a receiver;
**Figure 5** is a diagram of a receiver;
**Figure 6** is a diagram of a receiver;
**Figure 7** is a diagram of another concentrating photovoltaic unit;
**Figure 8** is a diagram of a concentrating photovoltaic unit in accordance with an advantageous embodiment of the present invention.

### DETAILED DESCRIPTION OF THE INVENTION

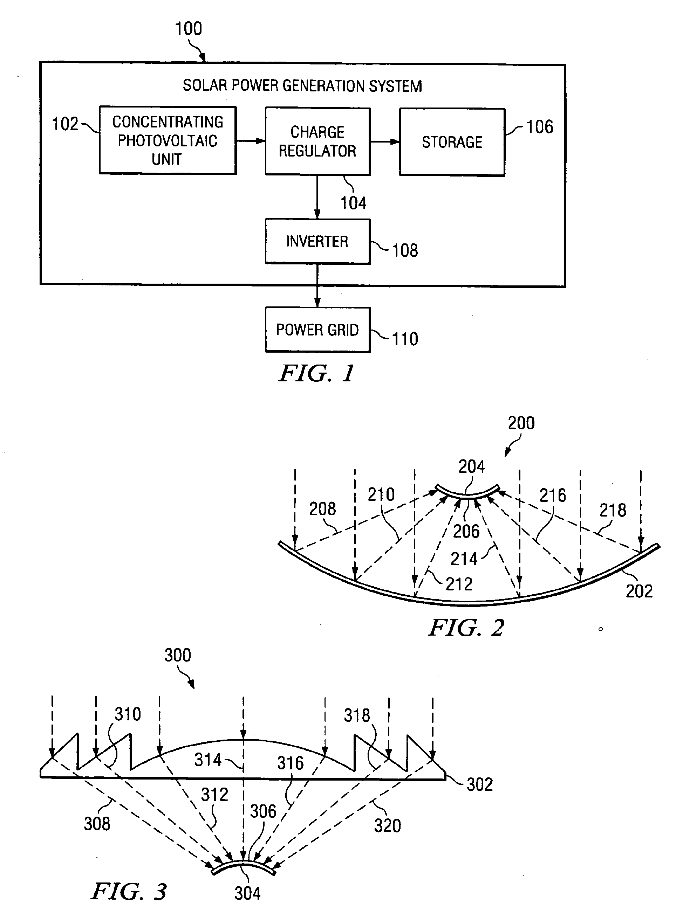

With reference now to the figures and in particular with reference to **Figure 1****,** a diagram illustrating a solar-powered generation system is depicted in accordance with an advantageous embodiment of the present invention. Solar-powered generation system **100** is an example of a solar-powered generation system in which different embodiments of the present invention may be implemented.

Solar-powered generation system **100** includes a concentrating photovoltaic unit **102,** charge regulator **104,** storage **106,** and inverter **108.** Concentrating photovoltaic unit **102** contains concentrating optics with a receiver area containing one or more solar cells to generate energy from sunlight. Charge regulator **104** is used to direct electricity generated by concentrating photovoltaic unit **102** to storage **106** or to inverter **108.** Charge regulator **104** ensures that batteries in storage **106** are charged and protects those batteries from discharging. Storage **106** is an optional component for these examples. Inverter **108** is used to convert DC voltage to AC voltage for use by power grid **110.** The particular configuration and components shown are for purposes of illustration and not meant to limit the architecture in which the different embodiments may be implemented.

In these illustrative embodiments, the receiver in concentrating photovoltaic unit **102** is modified from the substantially flat receiver area currently used in these types of systems. A curved receiver matching the curved focal plane produced by the concentrating optics is used in concentrating photovoltaic unit **102** in accordance with an advantageous embodiment of the present invention.

With reference next to **Figure 2****,** a diagram illustrating a concentrating photovoltaic system is depicted. In this example, concentrating photovoltaic system **200** includes concentrating reflective optic unit **202** and curved receiver **204.**

As depicted, curved receiver **204** takes a convex form such that surface **206** is curved in a manner that allows for concentrated illumination from concentrating reflective optic unit **202** to be normally incident on solar cells located on curved receiver **204.** In other words, light rays **208, 210, 212, 214, 216,** and **218** hitting concentrating reflective optic unit **202** are reflected in a manner to hit surface **206** at an angle that is around 90 degrees. The angle at which the different light rays reach surface **206** of curved receiver **204** are all around the same angle.

As a result, the illumination of solar cells on surface **206** is substantially the same for all of the solar cells. In this manner, the angle of incidence across surface **206** may all be around 90 degrees as desired to maximize the power output of solar cells for curved receiver **204.** Further, problems associated with light hitting a single solar cell at different angles or solar cells connected in a circuit at different angles are reduced. In this manner, the current output developed in the cells remain more uniform leading to less resistive power loss and less unpredictable electrical fields to reduce degradation of these cells.

These advantages are provided by curving surface **206** in a manner that allows light rays, such as light rays **208, 210, 212, 214, 216,** and **218** to hit surface 206 at around the same angle. In these examples, the desired angle is around 90 degrees or around perpendicular to surface **206.**

Turning now to **Figure 3****,** a diagram of another concentrating photovoltaic unit is depicted. In this example, concentrating photovoltaic unit **300** is an example of a system that may be used to implement concentrating photovoltaic unit **102** in **Figure 1****.** In this depicted example, concentrating refractive optic **302** takes the form of a concentrating lens rather than a mirror as illustrated in **Figure 2****.** In this particular arrangement, concentrating refractive optic **302** is a Fresnel lens. As illustrated, receiver **304** also is curved rather than being flat as in currently-used receiver systems. Surface **306** of receiver **304** contains one or more solar cells. These solar cells generate energy when light rays, such as light rays **308, 310, 312, 314, 316, 318,** and **320** are directed to surface **306** of receiver **304** through concentrating refractive optic **302.**

Surface **306** is curved in a manner such that these light rays hit surface **306** as incident light In other words, these light rays hit curved surface **306** at an angle of around 90 degrees. Surface **306** is curved in a manner such that these light rays all hit at around the same angle such that the portions of a cell or different cells in a same circuit all generate around the same amount of energy. This uniform current output leads to longer cell life as compared to currently used systems.

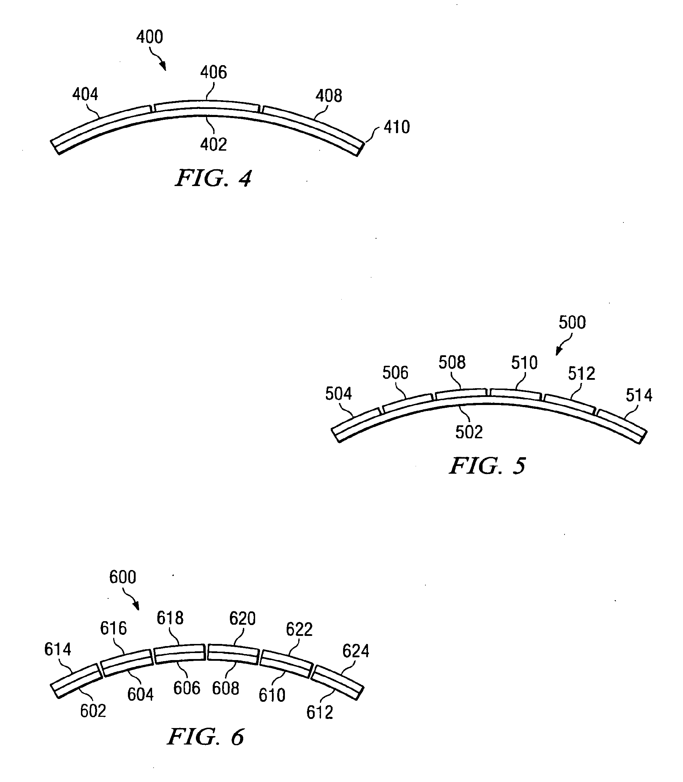

Turning now to **Figure 4****,** a diagram of a receiver is depicted. In this example, receiver **400** is an example of receiver **204** in **Figure 2****.** In this particular implementation, receiver **400** includes curved receiver heat sink **402.** Flexible solar cells **404, 406,** and **408** are mounted on surface **410** of curved receiver heat sink **402.** In this particular example, these flexible solar cells conform to the curved shape of curved receiver heat sink **402.** Flexible solar cells **404, 406,** and **408** may be implemented using any available flexible solar cells. Flexible cells might be made from thin multijunction material available from Spectrolab, crystalline silicon cells, or thin-film solar cell materials. These materials may be, for example, polycrystalline silicon, amorphous silicon, cadmium telluride, copper indium selenide, copper indium gallium selenide, or organic materials. In this example, curved receiver heat sink **402** is a single heat sink on which solar cells **404, 406,** and **408** are mounted.

urning next to **Figure 5****,** a diagram of a receiver is depicted. In this example, receiver **500** includes curved receiver heat sink **502,** which is a single piece in this example. Solar cells **504, 506, 508, 510, 512,** and **514** are mounted on surface **500** of curved receiver heat sink **502.** In this particular example, these solar cells are not flexible cells but are rigid flat cells tiled to conform to the curved shape of curved receiver heat sink **502.**

Turning now to **Figure 6****,** a diagram of a receiver is depicted. Curved receiver heat sink **600** is an example of a receiver that may be used to implement receiver **204** in **Figure 2** or receiver **304** in **Figure 3****.** In this example, receiver **600** includes heat sinks **602, 604, 606, 608, 610,** and **612.** Solar cells **614, 616, 618, 620, 622,** and **624** are mounted on these heat sinks. As with the solar cells depicted in **Figure 5****,** these solar cells are rigid flat cells in which a single solar cell is mounted to each heat sink. Heat sinks **602, 604, 606, 608, 610,** and **612** are tiled on a structure and receiver 600 to conform to a curved shape as illustrated.

The solar cells illustrated in these examples may be implemented using any available rigid or flexible solar cell. For example, the rigid solar cells may be implemented using 1-cm² CITJ or CUTJ cells, which are available from Spectrolab, Inc. The receivers depicted in **Figures 4, 5,** and **6** only illustrate the heat sinks and the solar cells, leaving out other components and the wiring for the solar cells to emphasize the features of the present invention.

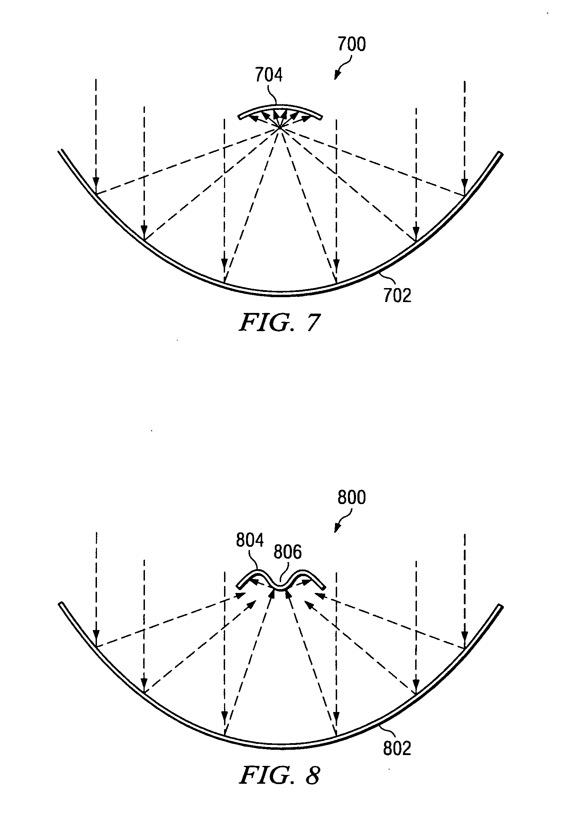

Turning now to **Figure 7****,** a diagram of another configuration for a concentrating photovoltaic unit is depicted. In this example, photovoltaic unit **700** has concentrating refractive optic **702** and receiver **704** has a concave shape. This receiver is concave or "cupped" in shape to reduce light loss by reflection off solar cells on receiver **704.**

With reference now to **Figure 8****,** a diagram of a concentrating photovoltaic unit is depicted in accordance with an advantageous embodiment of the present invention. In this example, photovoltaic unit **800** includes concentrating reflective optic **802** and receiver **804.** The particular configuration of receiver **804** in this example includes bulge **806.** Bulge **806** is used to intentionally deflect some of the incident light onto adjacent solar cells in response to excess light that occurs from a "hot spot" caused by imperfections in concentrating reflective optic **802.**

Thus, the different arrangements provide a method and apparatus for concentrating light on a receiver. In these examples, the apparatus includes a concentrating optic unit in which the concentrating optic unit has a curved surface and wherein the curved surface reflects light rays to perform reflective light rays. A curved receiver is positioned to receive the reflective light rays. A set of solar cells are attached to the surface of the curved receiver. The curved receiver has a shape such that the reflective light rays hit the surfaces of the set of solar cells at an angle that is substantially perpendicular to the surfaces in these examples.

As a result, the different arrangements allow for reduced costs in creating concentrating photovoltaic systems. With the use of a curved receiver, the different embodiments use curves such that the light hits at a nearly normal incident angle, around 90 degrees. With this type of design, with the slight changes in this angle, the light is less likely to miss hitting the receiver area as opposed to the light hitting a flat receiver at an oblique angle. In the current designs, slight changes in these angles, such as poor tracking of the sun, may cause the light to entirely miss the receiver.

Further, by providing more uniform intensity, potential differences are reduced within a solar cell and between cells connected in a circuit, cell life is increased in these types of systems. In addition, each solar cell is able to generate more electricity with the more uniform striking of light rays close to a desired angle, such as 90 degrees. With the solar cells creating more electricity per solar cell or module, fewer solar cells are needed to generate a desired amount of electricity. Further, in the advantageous embodiments, a costly high precision tracking system is no longer required because tracking requirements may be relaxed. As a result, this relaxation in tracking requirements also reduces the cost of a concentrating photovoltaic system.

Further, although the depicted examples illustrate the use of a photovoltaic system for generating energy for a power grid, the concentrating photovoltaic system illustrated may be implemented for other uses, such as in spacecraft, ships, or powering individual devices or small groups of buildings.

Although in the depicted examples, the angle desired is around 90 degrees, other angels may be used depending on the particular implementation. For example, larger angles may be used and grazing angles may allow for total internal reflection and trapping effects in the solar cells. A "cupped", or concave receiver, for example, would increase the trapping of light initially reflected off the cells. The anti-reflective coating used to minimize loss of light by external reflection is usually designed assuming 90-degree incidence. This angle, however, may be a different angle. In that case, the angle at which the light ray is hit should match as closely as possible that other angle in these examples.

Although the depicted examples are a simple curve, other curves with more complex shapes may be used depending on the particular implementation. For example, the receiver may have a shape of two curves with the ends of the curves joined to each other.

One application of this would be to re-distribute excess illumination to compensate for a hot spot caused by the concentrating optics. Optics such as Fresnel lenses can often cause a hot spot of excess intensity at the center of a receiver. A bulge in the shape of the center of the receiver would allow more of the incident illumination in the hot spot to be reflected and absorbed by adjacent cells outside the hot spot area, improving the illumination uniformity. In general, the particular shapes used are ones to match the shapes or the manner in which concentrating optics focus light to the receiver area.

The description of the present invention has been presented for purposes of illustration and description, and is not intended to be exhaustive or limited to the invention in the form disclosed. Many modifications and variations will be apparent to those of ordinary skill in the art.

## Claims

1. A concentrating photovoltaic system (800) comprising:
a concentrating optic unit (802);
a curved receiver (804) positioned to receive reflected light rays reflected by the concentrating optic unit; and
a set of solar cells attached to a surface of the curved receiver, **characterised in that:**
the receiver has a substantially concave form with a bulge (806) in the centre of the receiver (804) extending towards the concentrating optic unit (802); and
wherein the bulge (806) in the curved receiver has a shape such that some of the reflected light rays are reflected from a solar cell and absorbed by adjacent solar cells.

2. The concentrating photovoltaic system of claim 1, further comprising:
a positioning assembly, wherein the positioning assembly attaches the curved receiver to the concentrating optic unit..

3. The concentrating photovoltaic system of claim 1, wherein the concentrating optic member (802) is a concentrating reflective optic unit,

4. The concentrating photovoltaic system of claim 1, wherein the concentrating optic member is a concentrating refractive optic unit.

## Patentansprüche

1. Konzentrierendes photovoltaisches System (800) umfassend:
- eine konzentrierende optische Einheit (802);
- einen gekrümmten Empfänger (804), der zum Empfangen von reflektierten Lichtstrahlen angeordnet ist, die von der konzentrierenden optischen Einheit reflektiert werden; und
- eine Reihe von Solarzellen, die an einer Oberfläche des gekrümmten Empfängers befestigt sind;
**dadurch gekennzeichnet, dass** der Empfänger eine im Wesentlichen konkave Form mit einer Wölbung (806) in der Mitte des Empfängers (804) aufweist, die sich in Richtung der konzentrierenden optischen Einheit (802) erstreckt, und dass die in dem gekrümmten Empfänger ausgebildete Wölbung (806) eine Form aufweist, wodurch einige der reflektierten Lichtstrahlen von einer Solarzelle reflektiert und von benachbarten Solarzellen absorbiert werden.

2. Konzentrierendes photovoltaisches System nach Anspruch 1, das ferner eine Positioniereinrichtung aufweist, wobei die Positioniereinrichtung den gekrümmten Empfänger an der konzentrierenden optischen Einheit befestigt.

3. Konzentrierendes photovoltaisches System nach Anspruch 1, worin das konzentrierende optische Element (802) als konzentrierende reflektierende optische Einheit ausgebildet ist.

4. Konzentrierendes photovoltaisches System nach Anspruch 1, worin das konzentrierende optische Element als konzentrierende lichtbrechende optischen Einheit ausgebildet ist.

## Revendications

1. Système photovoltaïque de concentration (800) comprenant:
une unité optique de concentration (802);
un récepteur courbé (804) positionné pour recevoir des rayons de lumière réfléchis par l'unité optique de concentration; et
un ensemble de cellules solaires fixées à une surface du récepteur courbée,
**caractérisé en ce que**:
le récepteur a une forme sensiblement concave avec un bombement (806) dans le centre du récepteur (804) s'étendant vers l'unité optique de concentration (802); et
où le bombement (806) dans le récepteur courbé a une forme telle que quelques-uns des rayons de lumière réfléchis sont réfléchis d'une cellule solaire et sont absorbées par des cellules solaires adjacentes.

2. Système photovoltaïque de concentration selon la revendication 1, comprenant en outre:
un ensemble de positionnement, où l'ensemble de positionnement fixe le récepteur courbé à l'unité optique de concentration.

3. Système photovoltaïque de concentration selon la revendication 1, dans lequel l'élément optique de concentration (802) est une unité optique réfléchissante de concentration.

4. Système photovoltaïque de concentration selon la revendication 1, dans lequel l'élément optique de concentration est une unité optique réfractive de concentration.
